Europäisches Patentamt

European Patent Office

Office européen des brevets

(19)

(11) Publication number: **0 271 291 B1**

# EUROPEAN PATENT SPECIFICATION

(12)

(45) Date of publication of patent specification: **26.05.93**

(51) Int. Cl.⁵: **H01L 45/00, G02F 1/133**

(21) Application number: **87310658.7**

(22) Date of filing: **03.12.87**

(54) **MIM-diode having mixed oxide insulator.**

(30) Priority: **08.12.86 US 938890**

(43) Date of publication of application:
**15.06.88 Bulletin 88/24**

(45) Publication of the grant of the patent:
**26.05.93 Bulletin 93/21**

(84) Designated Contracting States:
**DE ES FR GB IT**

(56) References cited:
**EP-A- 0 150 798**
**WO-A- 86/05003**
**GB-A- 2 091 468**
**US-A- 3 359 466**

**APPLIED PHYSICS LETTERS, vol. 44, no. 6, March 1984, pages 642-644, American Institute of Physics, New York, US; G.D. O'CLOCK, Jr. et al.: "Performance of Ta-Ta2O5-Au metal-insulator-metal devices"**

(73) Proprietor: **GENERAL ELECTRIC COMPANY**
**1 River Road**
**Schenectady New York 10022(US)**

(72) Inventor: **Furst, David Arthur**
**21 Tar Heels Road**
**Mercerville New Jersey(US)**
Inventor: **Vieland, Leon Joseph**
**62 Snowden Lane**
**Princeton New Jersey(US)**

(74) Representative: **Lupton, Frederick et al**
**LONDON PATENT OPERATION, G.E. TECH-NICAL SERVICES Co. INC., Essex House,**
**12/13 Essex Street**
**London WC2R 3AA (GB)**

## Description

The present invention relates to a metal−insulator−metal (MIM) type diode, such as a diode which is used as a switching element for a pixel that is part of a high resolution liquid crystal display (LCD).

Switching elements, such as MIM diodes, are series coupled with pixels in a so−called "active matrix" LCD in order to improve the contrast ratio of multiplexed displays. When the switching element is turned ON (conducting) by a drive voltage, current flows therethrough, and charge is stored in the pixel. When the switching element is turned OFF (non−conducting), the charge must remain stored in the pixel.

For a high level of multiplexing, the switching element is ON only for a short time. Since the desired stored charge is fixed, a relatively high current must flow when the switching element is ON; therefore, the switching element must have a low ON resistance. Conversely, when the switching element is OFF, the leakage current must be low so that the pixel retains the stored charge. Thus, the OFF resistance must be high. The rate at which the current non−linearly increases with voltage is thus one measure of the quality of the switching element. Additionally, the element must operate between voltage limits set by the characteristics of the pixel and the external drive circuitry. That is, the magnitude of the current at any fixed voltage must be scaled to match the pixel.

Prior art MIM diodes meet the requirement of high OFF to ON resistance (switching ratio) by using a thin insulator, e.g., 40 to 60 nm. The low OFF resistance which obtains is partially compensated for by making very small area elements. Nevertheless, the working voltage range of these elements is lower than required for optimal display quality; e.g., the contrast ratio degrades rapidly with temperature increases and manufacturing variability of the diodes. Alternatively, increasing the OFF resistance by having a thicker insulator degrades the switching quality (non−linearity) of the elements.

WO−A−86/05003 describes a MIM switching diode for an LCD, comprising first and second electrodes with oxide therebetween, the first electrode comprising a finger of oxidised tantalum, and the second electrode chromium.

EP−A−0150798 discloses diodes, for drawing pixels, formed from an amorphous silicon alloy, with a bus formed from molybdenum tantalum alloy.

GB−A−2091468 describes a MIM device having a tantalum or molybdenum thin film electrode, which is oxidised to form an oxide insulator for the device.

It is therefore desirable to have a MIM diode that has a higher resistance at low voltages, together with a sufficient non−linearity, thus providing a high operating range and hence greater tolerance against LCD picture degradation due to temperature changes and manufacturing variabilities.

A diode according to the present invention comprises a MIM diode comprising first and second electrodes and an insulator disposed between the said first and second electrodes, said insulator being substantially a mixture of $Ta_2O_5$ and another oxide, characterized in that the said another oxide is $Al_2O_3$, having an average mole percent of between 40 and 70 for the insulator between the said first and second electrodes as a whole, or $SiO_2$, having an average mole percent between 10 and 50 for the insulator between the said first and second electrodes as a whole.

In the drawings :

FIGURE 1 shows a MIM diode embodying the invention;

FIGURES 2−4 show the diode of FIGURE 1 during sequential manufacturing steps; and

FIGURES 5 and 6 show the voltage at fixed current for MIM diodes of varying insulator mixtures.

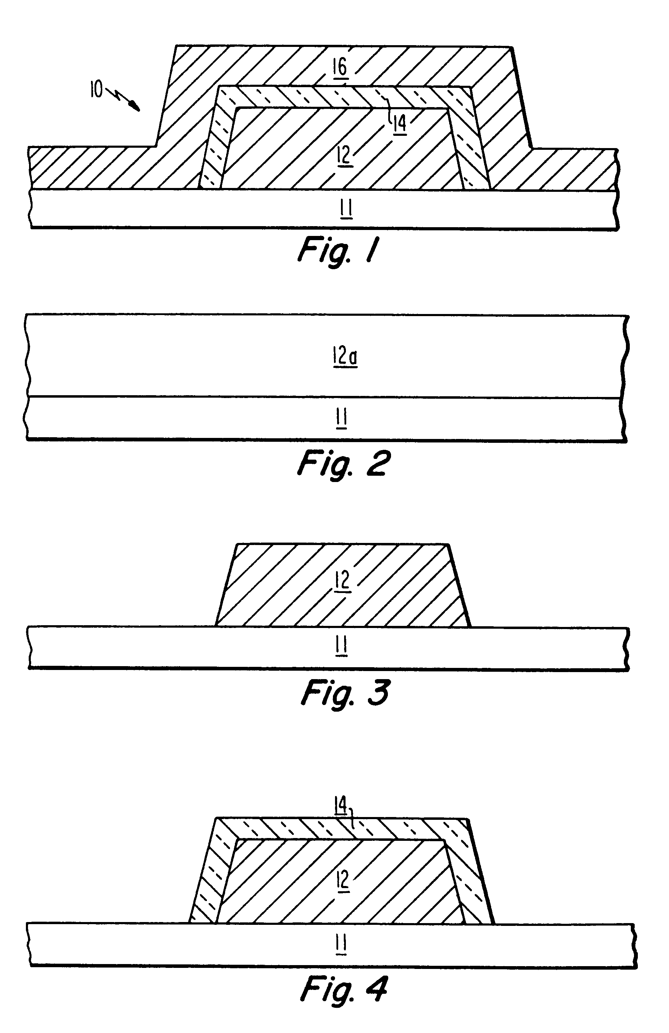

In FIGURE 1, a MIM diode 10 on a substrate 11 is shown. Overlying the substrate 11 is a first electrode 12 of about 200−500 nm thickness. The electrode 12 extends perpendicular to the plane of the drawing and contacts an address line of an LCD (not shown). Overlying the first electrode 12 is an insulator 14 having a thickness in the range of 35 to 80 nm. If this thickness is less than about 35 nm, pinholes can occur that short circuit the diode 10; for a thickness greater than about 80 nm, sufficiently non−linear MIM diode conduction does not occur. A second electrode 16 is opposed to the electrode 12, has a thickness between about 100 and 200 nm, overlies the insulator 14, and extends in the plane of the drawing to contact a pixel electrode (not shown).

The substrate 11 can comprise an insulating material such as glass. The first electrode 12 can comprise a conductor such as a mixture of Ta and between 10 and 50 atomic percent Si or between 40 and 70 atomic percent Al. The insulator 14 is substantially a mixture of $Ta_2O_5$ and another oxide. The other oxide is $Al_2O_3$, having an average mole percent of between 40 and 70 for the insulator 14 between the electrodes 12, 16 as a whole, or $SiO_2$, having an average mole percent of between 10 and 50 for the insulator 14 between the electrodes 12, 16 as a whole. These limits represent the ranges over which useful changes in resistivity occur as compared to a pure $Ta_2O_5$ insulator. By "average mole percent" is meant the mole percent for the insulator 14 as a whole, even though at some locations, e.g., near the electrodes 12 and 16, the mole percent can differ. The second electrode 16 comprises a good conductor such as Al or Cr.

In FIGURE 2, a layer 12a is formed in a particular embodiment by radio frequency co−sputtering of Ta and Si or Ta and Al. A power density of about 2.3 watts/cm$^2$ and an Ar pressure of about 15 millitorr, (about 2Pa) are used. The layer 12a is then defined into the first electrode 12 by reactive ion etching using, e.g., a plasma of $CF_4$ and $O_2$, as shown in FIGURE 3. Thereafter, the insulator 14 is formed by anodization using a 0.01% (by weight) citric acid solution, with the first electrode 12 being the anode (positive voltage applied thereto). Then, the second electrode 16 is formed by vacuum deposition, such as evaporation or sputtering, to form the diode 10 of FIGURE 1. Thereafter, the diode 10 is annealed at about 250˚C for about 20 minutes so that it has stable and repeatable characteristics.

An equation which closely approximates the current (i)−voltage (v) characteristic of a MIM diode is:

$$i = i_o exp\beta\sqrt{v}$$

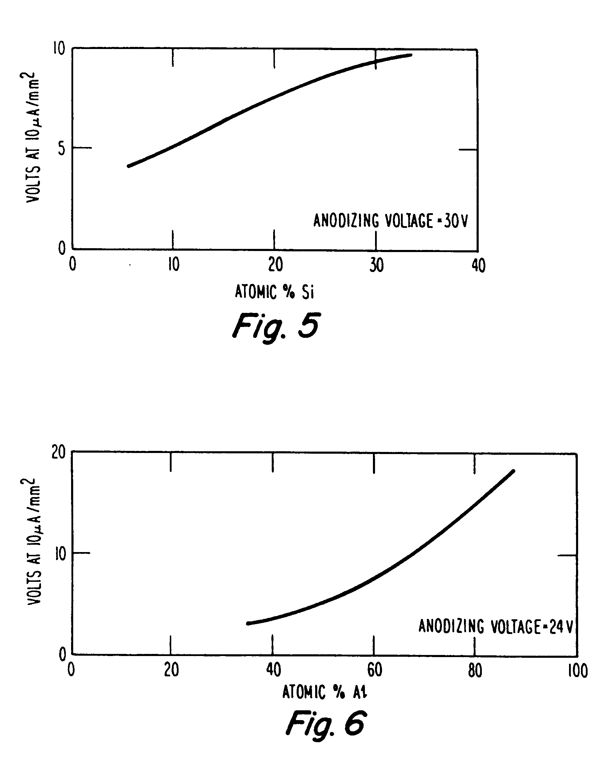

wherein $i_o$ and $\beta$ are constants. Beta ($\beta$) is a measure of the non−linearity of the device; higher values of $\beta$ represent diodes with better switching characteristics. Beta is an inverse function of the square root of the high frequency dielectric constant of the insulator 14. For a given $\beta$, $i_o$ then determines the scale of drive and operating voltages of the LCD. Another useful parameter is V−(j), which is the voltage needed to produce a selected current density j measured in microampere/mm$^2$($\mu$A/mm$^2$). The general trend of the effective resistivity of the oxide mixtures is given in FIGURES 5 and 6 for Si and Al mixtures, respectively, wherein the voltage at a current density of 10$\mu$A/mm$^2$, V(10), is plotted as a function of the composition in atomic percent of the first electrode 12. These graphs were obtained from samples having laterally graded composition of the first electrode 12 obtained by co−sputtering of asymmetrical targets. The principal effect of adding the Si or Al oxides to $Ta_2O_5$ is to move the operating voltage range towards higher values. Values of V(10) up to about 10 volts are the most useful in LCDs. For the examples below, V(j = 1) or V(1), is given. For a typical pixel having a capacitance of about 1 picofarad and a device area of 30−100 square micrometers, V(1) is about 1 to 1.5 times the maximum possible stored voltage for a high contrast and high resolution display. All values for $\beta$, $i_o$, and V(1) are averages for the two conduction directions since conduction in a MIM diode is asymmetrical.

EXAMPLE NO. 1

The first electrode comprised a mixture of Ta and about 29 atomic percent Si, which was anodized in dilute citric acid using a constant 30 volts for 3 hours to form the insulator 14 having a thickness of about 50 nm. The second electrode 16 was then formed by evaporation, resulting in a MIM diode having $\beta$ = 4.7, $i_o$ = 9.0 x 10$^{-12}$ ampere/square millimeter (A/mm$^2$) and V(1) = 6.1 volts.

EXAMPLE NO. 2

The first electrode 12 comprised a mixture of Ta and about 36 atomic percent Si, which was anodized at a constant 24 volts for 3 hours to form the insulator 14 having a thickness of about 40 nm. In this case $\beta$ = 4.8, $i_o$ = 2.4 x 10$^{-10}$ A/mm$^2$, and V(1) = 3.0 volts.

EXAMPLE NO. 3

The first electrode 12 comprised a mixture of Ta and about 58 atomic percent Al, which was anodized at a constant 24 volts for 3 hours to form insulator 14 having a thickness of about 40 nm. In this case, $\beta$ = 4.1, $i_o$ = 2.8 x 10$^{-10}$ A/mm$^2$, and V(1) = 4 volts.

COUNTEREXAMPLE

The first electrode 12 comprised nearly pure Ta that was anodized at a constant 30 volts for 3 hours to form insulator 14 having a thickness of about 50 nm. In this case, $\beta$ = 3.68, $i_o$ = 9.3 x 10$^{-9}$ A/mm$^2$, and V(1) = 1.6 volts.

It will thus be appreciated that the examples provided diodes having a greater P and V(1) and a lower $i_o$ than the counter example, thereby resulting in a diode better suited to driving an LCD. In particular, the greater $\beta$ provides better switching, and, further, sufficiently lower $i_o$ is obtained so that adequate charge storage is obtained at higher voltages. It has also been found that the dielectric constant of MIM diodes embodying the invention is lower compared to the prior art MIM diodes. This reduces parasitic shunt capacitance, thereby also contributing to a diode better suited to driving an LCD.

**Claims**

1. A MIM diode comprising first and second electrodes (12, 16) and an insulator (14) disposed between the said first and second electrodes (12, 16), said insulator (14) being substantially a mixture of $Ta_2O_5$ and another oxide, characterized in that the said another oxide is $Al_2O_3$, having an average mole percent of between 40 and 70 for the insulator (14) between the said first and second electrodes (12, 16) as a whole, or $SiO_2$, having an average mole percent between 10 and 50 for the insulator (14) between the said first and second electrodes (12, 16) as a whole.

2. A MIM diode according to Claim 1, wherein said insulator (14) has a thickness in the range of 35 nm to 80 nm.

3. A MIM diode according to either of Claims 1 and 2, wherein the first electrode (12) comprises a mixture of Ta and either Si or Al.

4. A MIM diode according to any one of the preceding claims, wherein the second electrode (16) comprises a metal conductor.

5. A MIM diode according to any one of Claims 1 to 4, wherein the second electrode (16) comprises Al or Cr.

**Patentansprüche**

1. MIM − Diode mit einer ersten und einer zweiten Elektrode (12,16) und einem zwischen dieser ersten und zweiten Elektrode (14,16) angeordneten Isolator (14), der im wesentlichen durch eine Mischung von $Ta_2O_5$ und einem anderen Oxid gebildet wird, **dadurch gekennezeichnet**, daß das andere Oxid $Al_2O_3$ ist und einen mittleren Mol − Prozentsatz zwischen 40 und 70 für den zwischen der ersten und zweiten Elektrode (12,16) befindlichen Isolator (14) als Ganzes aufweist, oder $SiO_2$ mit einem mittleren MOL − Prozentsatz zwischen 10 und 50 für den zwischen der ersten und zweiten Elektrode (12,16) befindlichen Isolator (14) als Ganzes.

2. MIM − Diode nach Anspruch 1, **dadurch gekennzeichnet**, daß die Dicke des Isolators (14) im Bereich von 35 nm bis 80 nm liegt.

3. MIM − Diode nach einem der Ansprüche 1 und 2, **dadurch gekennzeichnet**, daß die erste Diode (12) eine Mischung aus Ta und entweder Si oder Al aufweist.

4. MIM − Diode nach einem der vorstehenden Ansprüche, bei welcher die zweite Elektrode (16) einen Metalleiter aufweist.

5. MIM − Diode nach einem der Ansprüche 1 bis 4, bei welcher die zweite Diode (16) Aluminium oder Chrom aufweist.

**Revendications**

1. Diode M I M comprenant une première et une seconde électrodes (12, 16) et un isolant (14) disposé entre ladite première et ladite seconde électrodes (12, 16), ledit isolant (14) étant sensiblement constitué d'un mélange de $Ta_2O_5$ et d'un autre oxyde, caractérisé en ce que ledit autre oxyde est $Al_2O_3$, comprenant un pourcentage molaire moyen compris entre 40 et 70 pour l'isolant (14) entre la première et la seconde électrodes (12, 16) considérés com−me un ensemble, ou $SiO_2$ comprenant un pourcentage molaire moyen compris entre 10 et 50 pour l'isolant (14) entre ladite première et ladite seconde électrodes (12, 16) en tant qu'ensemble.

2. Diode M I M selon la revendication 1 dans laquelle ledit isolant (14) présente une épaisseur située dans le domaine de 35 nm à 80 nm.

3. Diode M I M selon l'une ou l'autre des revendications 1 et 2 dans laquelle la première électrode (12) comprend un mélange de Ta et soit Si ou Al.

4. Diode M I M selon l'une quelconque des revendications précédentes dans laquelle la seconde électrode (16) comprend un conducteur métallique.

5. Diode M I M selon l'une quelconque des revendications 1 à 4, dans laquelle la seconde électrode (16) comprend Al ou Cr.

Fig. 1

Fig. 2

Fig. 3

Fig. 4

Fig. 5

Fig. 6